# EUROPEAN PATENT APPLICATION

(11) **EP 4 506 761 A2**
(43) Date of publication of application: **12.02.2025**
(21) Application number: 24192805.0
(22) Date of filing: 05.08.2024
(51) Int. Cl.: G03F 7/34, G03F 7/36

(54) **THERMAL DEVELOPMENT APPARATUS OF A FLEXOGRAPHIC PLATE**

(30) Priority: 07.08.2023 IT 202300016881
(71) Applicant: Vianord Engineering Sasu, 06510 Carros (FR)
(72) Inventor: DE CARIA, Riccardo, 20080 Basiglio (MI) (IT)
(74) Representative: De Bortoli, Tiziano

(57) **Abstract**

The present invention relates to a thermal development apparatus (1) for removing non-crosslinked polymer or monomer from a first surface (5a) of a flexographic plate (5). The apparatus according to the invention comprises a moving assembly (10) defining a support surface (11a) for the plate (5), wherein said moving assembly (10) moves said flexographic plate (5) along a predetermined trajectory. According to the invention, said moving assembly (10) comprises a support cylinder (11) which includes a cylindrical body (11') that develops around a longitudinal axis (100), wherein said support cylinder (11) further includes a cover layer (11') which partially covers an outermost surface (18) of said cylindrical body (11) and defines said support surface (11a) for said plate (5); Said moving assembly (10) also comprises a plurality of connecting pins (43) connected, directly or indirectly, to said outermost surface (18) of said cylindrical body (11) at a cutoff region (60) of said cover layer (11'), wherein said pins (43) are aligned parallel to said longitudinal axis (100) and wherein, for each pin (43), the radial distance (R1, R*) between said longitudinal axis (100) and a free end (431) of said pin (43) is less than the radial distance (R₂) between said longitudinal axis (100) and the support surface (11a) defined by said cover layer (11').

## Description

### FIELD OF THE INVENTION

The present invention falls within the field of the manufacture of systems for preparing digital flexographic printing plates. In particular, the present invention relates to a thermal development apparatus of a flexographic plate

### BACKGROUND ART

Flexography is a direct rotary printing method that uses relief plates made of photopolymer materials. The plates are flexible and soft, hence the name flexography. These plates are inked and the print is obtained by direct deposition of the ink on the medium to be printed due to a light pressure applied by a printing cylinder on which the plates are positioned.

Flexography is a high-speed printing process capable of printing on many types of absorbent and non-absorbent materials. Some typical applications of flexographic printing are the production of paper and plastic bags, milk cartons, disposable cups, and the like; however, thanks to current advances in print quality, flexographic printing is also used, for example, to print newspapers, envelopes, labels, and to print on plastic, acetate films and sheets, wrapping paper and various materials used for product packaging.

A particular flexographic printing process is *"digital flexography",* in which digital plates *(or "flexographic plates'')* are used. In these plates, the photopolymer is originally covered with a surface layer of a material that prevents photo-exposure, such as a layer of carbon or graphite. This layer of material is etched to create the negative image of the print subject. This etching step is typically carried out using a digital laser controlled by a computer *(hence the acronym CTP "computer to plate" used in the field to indicate this step of the preprinting process).*

The plate is then photo-exposed and the material not exposed to light is eliminated during an operation known as *"development of the flexographic plate* ".

According to a first known method, the development of a digital plate takes place through a washing operation which involves the use of a liquid *(water- or solvent- based)* intended to dissolve and/or soften the polymer or monomer previously not exposed to light. In presence of this liquid, the plate is subjected to the mechanical action of brushes that act on the surface of the plate to facilitate detachment of the monomer or polymer not exposed to light.

According to a second known method, alternative to washing, flexographic plates are thermally developed through a process that removes the polymer or monomer not exposed to light through contact with absorbent material, wherein this contact takes place when the unexposed polymer or monomer is brought to a temperature that melts it so that it flows into the absorbent material and hence so that it can be removed in contact with this material. Compared to the washing method, thermal development of the plates is a substantially *"dry"* method and hence does not require a drying time downstream of the development operation, said time instead being required by the development process involving washing with a liquid. In recent years, different apparatus for the thermal development of flexographic plates have been proposed. Examples of these apparatus are disclosed, for example, in EP1526410, EP2774003, EP1850183, and EP1553456.

In general, a thermal development apparatus of a flexographic plate comprises a moving assembly that supports the flexographic plate and moves the same along a predetermined trajectory. This moving assembly defines a moving support surface on which the flexographic plate is positioned. More precisely, the plate rests on this moving surface with a base surface *(or inner surface)* thereof opposite the outer surface previously exposed to light and hence requiring thermal development.

A conventional thermal development apparatus also comprises a development operating assembly to apply, during movement of the plate, the absorbent material to the outer surface of the plate, i.e., to develop the plate. Typically, a development operating assembly comprises heating means to bring the outer surface of the plate to a temperature sufficient to melt/liquefy the polymer and hence to allow its removal through contact with the absorbent material. For this purpose, the development operating assembly comprises feeding means of the absorbent material and contact means acting on the absorbent material to make it adhere to the outer surface of the plate so as to absorb, and hence remove, the non-crosslinked polymer/monomer.

Typically, the feeding means comprise a plurality of rollers/cylinders that configure a path for the absorbent material between a first roller, from which the absorbent material is unwound, and a last roller on which the material is rewound after contacting the outer surface of the plate. Usually, tensioning rollers are provided to maintain the correct feed tension of the absorbent material. The contact means act on the absorbent material at a predetermined point of its path causing it to adhere to the outer surface of the plate.

A known embodiment, for example schematically shown in EP1740392, provides for the use of a heating cylinder on a portion of which the absorbent material is conveyed. The heating cylinder is typically defined by a cylindrical body made of metal material and its outer surface, on which the absorbent material moves, is brought to a predetermined temperature by electric resistors arranged at the ends of the cylindrical body. In this embodiment, the contact means comprise a pushing unit that acts on the heating cylinder to bring the absorbent material, conveyed around the heating cylinder, in contact with the outer surface of the plate. From an operational viewpoint, during the development process the plate is moved several times along the path defined by the moving assembly and thus comes into contact several times with fresh absorbent material supplied by the feeding means. In the case in which movement of the plate is implemented by means of a motorized cylinder and in which a heating cylinder is used *(according to the solution described above),* during the process the plate is subjected to subsequent rotations, thus coming into contact, at each rotation, with the heating roller until complete removal of the non-crosslinked polymer/monomer, i.e., until complete development of the plate.

Still considering the moving assembly, according to a first known embodiment *(for example shown in* WO2022026980*,* EP2501550*, or* EP3033236*),* it comprises a conveyor configuration comprising two rollers *(at least one of which is motorized)* and a belt wound around the two rollers and moved thereby. The flexographic plate is positioned on this belt. Rotation of the two rollers causes movement of the belt, and hence of the flexographic plate integral therewith.

In an alternative embodiment, for example disclosed in EP1624343 or EP1899766, the moving assembly is provided with a single motorized cylinder on the surface of which the plate is positioned. In use, the cylinder is rotated about its longitudinal axis and the plate carries out corresponding rotations about the axis of the cylinder. Compared to the conveyor solution, the use of a single cylinder allows the dimensions of the apparatus to be limited and is simpler in terms of management and maintenance.

Typically, a motorized cylinder has a cylindrical body made of a metal material whose outer surface is completely covered with a material having elastic properties capable of operating, without deformation, at operating temperatures of around 150 °C. The flexographic plate rests on and is supported by the outer surface of the cover layer. Typically, to make the plate integral with the support surface of the cylinder *(i.e., with the outer surface of the cover layer)* a connection through a pin bar, i.e. a bar provided with a row of projecting pins, is used. The plate is positioned on the support surface of the support cylinder. A row of holes is formed in advance in the plate near an edge thereof and parallel to this edge. Adjacent holes of said row are spaced by a distance corresponding to the distance between adjacent pins of the pin bar. The plate is connected to the pin bar in such a way that the connection pins are inserted into corresponding holes, which have a suitable diameter for this purpose.

Another connection method is schematically shown in EP 277003 and provides for the use of a connecting bar positioned on top of the outer surface of the support cylinder and parallel to the axis of the cylinder. This connecting bar is supported by two support arms located at opposite ends of the support cylinder integral in rotation therewith. The plate rests on the outer surface of the support cylinder and an edge thereof is coupled to the connecting bar. When the cylinder rotates, due to the support arms, the connecting bar and the plate are also rotated.

As compared to the solution described in EP 277003, the pin bar connection is certainly simpler and less complex. However, also the current use of a pin bar has various drawbacks. The first of them lies in that, due to the positioning of the pin bar on the outer surface of the support cylinder, the rotation of the latter cannot be continuous, but has to be interrupted at each revolution. In fact, when the pin bar reaches a position close to the heating roller *(or more generally to the means that cause the contact of the absorbent material with the plate)* it is necessary to move the heating roller *(or other contact means used)* away to create enough space for the passage of the pin bar. This aspect naturally has a negative effect on the process times and hence on the final production costs. It is noted that this drawback also affects the solution described in EP 277003, in which a connecting bar positioned just above the outer surface of the support roller is used.

Another drawback related to the use of the pin bar lies in that at the edge where the holes are formed, a portion of the plate remains unusable, i.e., cannot be processed. Normally, this portion has a width of 40-50 mm measured from the edge close to the connecting holes. This portion becomes unusable because, due to the position of the pin bar *(on top of the outer surface of the support cylinder),* it cannot be reached by the contact means and hence by the absorbent material. In other words, this portion cannot be processed. In view of the high cost of the flexographic plates, it is apparent that this aspect further affects the production costs. The Applicant has therefore observed that there is a need to provide a new technical solution that allows the configuration of the moving assembly to be improved, particularly as far as the way of connecting the flexographic plate to the support cylinder.

### SUMMARY

The main aim of the present invention is to provide a thermal development apparatus of a flexographic plate that allows the aforesaid problem to be solved or limited. Within this aim, a first object is to provide a thermal development apparatus that that allows a simple connection of the flexographic plate to the support cylinder. A further object is to provide a thermal development apparatus that allows the process times to be reduced. Yet another object is to provide an apparatus that allows the overall costs of a flexographic print process to be reduced, in particular those linked to the cost of the plates. One more object of the present invention is to provide a thermal development apparatus of a plate that is reliable and easy to produce at competitive costs.

The Applicant has observed that this aim and these objects can be achieved by arranging connecting pins for the flexographic plate in a cutoff region of the cover layer of the support cylinder and in such a way that these pins do not extend radially beyond a reference circumference having a radius corresponding to radius of the outermost surface of the cover layer, i.e., of the support surface of the flexographic plate.

More precisely, the Applicant has observed that the aim and the objects described above can be achieved through a thermal development apparatus for removing non-crosslinked polymer or monomer from a first surface of a flexographic plate, wherein the apparatus comprises:
- a moving assembly defining a support surface for a second surface of the flexographic plate opposite the first surface, wherein the moving assembly moves the flexographic plate along a predetermined trajectory;
- a development operating assembly for applying an absorbent material to the first surface of the flexographic plate during the movement thereof, wherein said development operating assembly comprises:
- feeding means of the absorbent material;
- heating means for heating the first surface of the flexographic plate to a temperature sufficient to melt at least a portion of said non-crosslinked polymer/monomer;
- contact means configured to cause a contact between the absorbent material and the first surface of the flexographic plate to allow the melted polymer/monomer to be absorbed by the absorbent material.

According to the invention, the moving assembly comprises a support cylinder which includes a cylindrical body that develops around a longitudinal axis; the support cylinder also includes a cover layer which partially covers an outermost surface of the cylindrical body defining the support surface for the flexographic plate. The moving assembly further comprises a plurality of connecting pins connected, directly or indirectly, to the outermost surface of the cylindrical body at a cutoff region of the cover layer; these pins are aligned parallel to said longitudinal axis and for each pin the radial distance between said longitudinal axis and the free end of the pin is less than the radial distance between the longitudinal axis and the support surface defined by said cover layer.

According to a preferred embodiment, at least one of the pins comprises a base connected, directly or indirectly, to a non-covered portion of the outermost surface of the cylindrical body and a head enlarged with respect to the base, wherein said enlarged head defines the free end of the pin.

According to a possible embodiment, the pins are fixed directly to said non-covered portion by means of a threaded coupling. Preferably, said non-covered portion is flat-shaped.

According to another possible embodiment, the pins are fixed to a pin bar so as to emerge with respect to a first surface thereof, said pin bar being fixed directly, at a second surface opposite the first surface, to a non-covered portion of the outermost surface of the cylindrical body.

Preferably, the pins are fixed to the pin bar and the latter comprises a plurality of holes for positioning connecting means for connecting the pin bar to the non-covered portion of the cylindrical body.

According to an embodiment, the cover layer comprises at least two sub-layers, an innermost sub-layer having a hardness of around 40 *Shore* and an outermost sub-layer having a hardness of around 20 *Shore.*

According to an embodiment, the cylindrical body, considered on a cross-sectional plane orthogonal to the longitudinal axis, comprises an outermost cylindrical shell connected to a central shaft by means of heads, wherein said cylindrical shell is internally hollow and traversed by the central shaft, wherein said heads comprise connecting spokes between the central shaft and the cylindrical shell.

### LIST OF DRAWINGS

Further features and advantages of the present invention will be more apparent from the following detailed description, provided by way of non-limiting example and illustrated in the accompanying drawings, wherein:
- Fig. 1 is a schematic view of a possible embodiment of a thermal development apparatus of a flexographic plate according to the invention in a first operating configuration;
- Fig. 2 is a schematic view of the apparatus of Fig. 1 in a second operating configuration;
- Figs. 3 and 4 are detailed views of a portion of the moving assembly of the apparatus in Fig. 1 and in Fig. 2, respectively;
- Fig. 5 is a schematic plan view of the support cylinder of the moving assembly of the apparatus in Fig.1;
- Fig. 5A is a cross-sectional view according to the plane V-V in Fig.5;
- Fig. 6 is a detail view of a portion of a moving assembly of an apparatus according to the present invention;
- Fig. 7 is a schematic view of a component of the moving assembly in Fig.6;
- Fig. 7A is a schematic view of a flexographic plate which can be connected to a support cylinder of a moving assembly of an apparatus according to the invention;
- Fig. 8 is a schematic view of a further possible embodiment of a thermal development apparatus of a flexographic plate according to the invention in a first operating configuration;
- Fig. 9 is a schematic view of the apparatus in Fig.8 in a second operating configuration. The same reference numerals and letters in the figures define the same elements or components.

### DETAILED DESCRIPTION

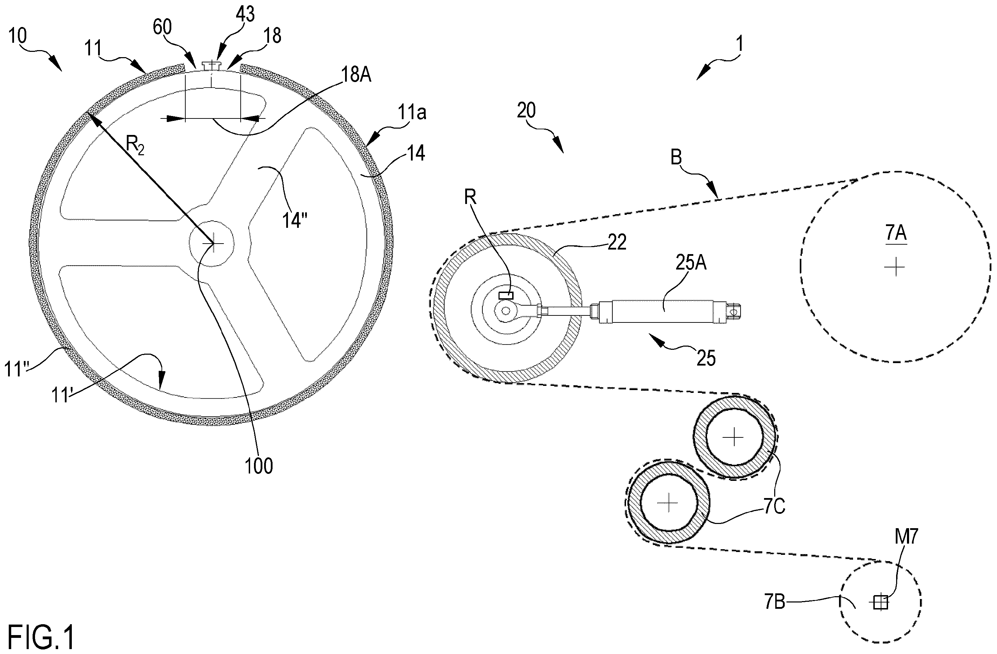

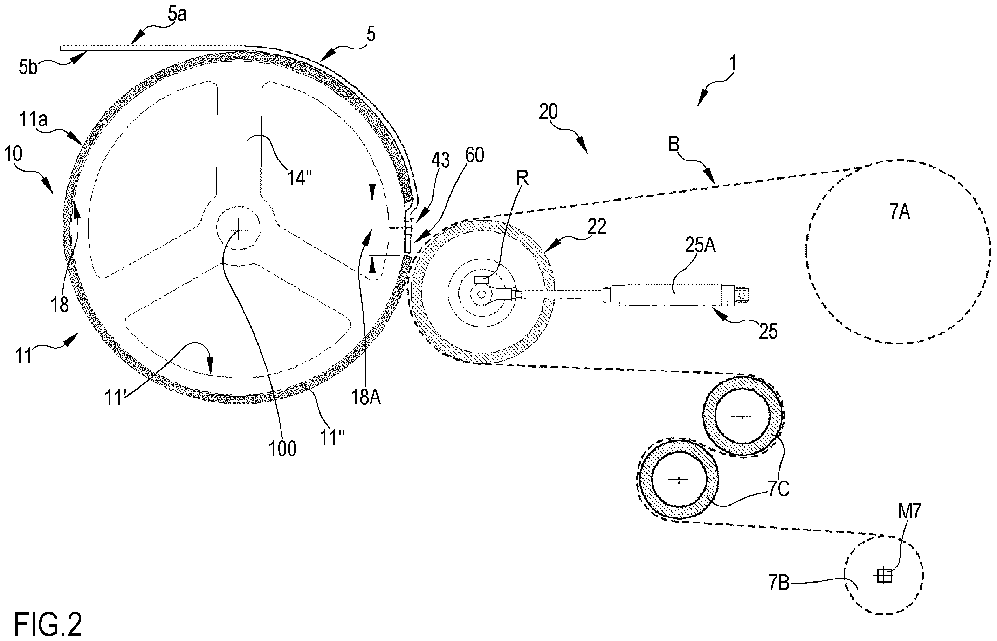

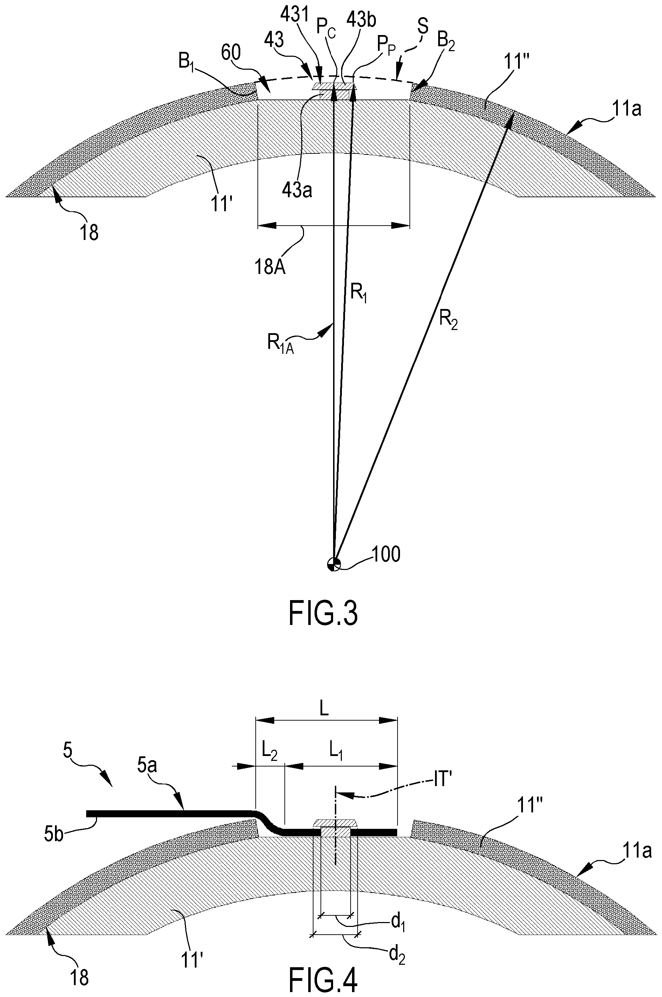

With reference to Figs. 1 to 6, the present invention relates to a thermal development apparatus 1 of a flexographic plate 5 *(hereinafter also indicated only as plate* 5) shown in Figs. 2 and 4. The plate 5 comprises a first surface 5a *(or outer surface 5a)* and a second surface 5b *(or inner surface 5b),* defining the *"base"* layer of the plate 5 which, according to a known solution, comprises a layer made of Mylar.

The purpose of the apparatus 1 according to the invention is to allow removal of the non-crosslinked polymer or monomer from the first surface 5a of the plate 5. The crosslinking process of the polymer or monomer of the plate can take place according to methods known to the person skilled in the art *(such as exposure to UV rays).* In any case, these methods are not relevant for the present invention.

The apparatus 1 comprises a moving assembly 10 for moving the plate 5, which defines a support surface 11a for said second surface 5b. The moving assembly 10 defines a movement trajectory along the which the plate 5 is moved. As better described below, the moving assembly 10 comprises a motorized support cylinder 11 *(hereinafter also indicated by the term cylinder 11)* operated by means of a motor M. The support cylinder 11 defines a support surface 11a which directly supports the plate 5.

The apparatus 1 according to the invention comprises a development operating assembly 20 *(hereinafter also indicated as operating assembly 20)* for applying an absorbent material B *(hereinafter also indicated by the term blotter B)* to the outer surface 5a of the plate 5 during the movement thereof along the trajectory defined by the moving assembly 10. Specifically, this operating assembly 20 comprises feeding means 7A, 7B, 7C having the function of continuously providing the absorbent material B necessary for developing the plate 5. Preferably, but not exclusively, these feeding means comprise at least one feeding cylinder 7A, one or more tensioning cylinders 7C, and a collecting cylinder 7B, preferably with parallel rotation axes. With reference to the *blotter B,* this can be of any known type suitable for the purpose.

The operating assembly 20 further comprises heating means R, 22 for heating the outer surface 5a of the plate 5 to a predetermined temperature such as to melt/liquefy at least a portion of the non-crosslinked polymer or monomer. Preferably, this predetermined temperature can vary in a range from 80 to 150 °C, depending on the type of material forming the plate 5.

The operating assembly 20 further comprises contact means 25-25A configured to make the absorbent material B adhere to the outer surface 5a of the plate 5 after or simultaneously to heating of the outer surface 5a. For this reason, the heating means R, 22 mentioned above are arranged at, or in any case in a position adjacent to, the contact means 25-25A.

According to the present invention, the moving assembly 10 comprises a support cylinder 11 *(hereinafter also indicated by the term cylinder 11)* which includes a cylindrical body 11' that develops around a longitudinal axis 100. The cylindrical body 11' comprises an outermost cylindrical surface *(indicated by reference numeral 18).*

The cylinder 11 further comprises a cover layer 11" that partially covers the outermost surface 18 of the cylindrical body 11'. The outermost surface of the cover layer 11' defines the support surface 11a on which the plate 5 rests during the thermal development process. Preferably, the cover layer 11" is made of an elastic material capable of withstanding, without deformation, operating temperatures of about 150 °C. Even more preferably, the cover layer 11" is formed of two sub-layers, an internal sub-layer having a hardness of about 40 *Shore* and an external sub-layer having a hardness of about 20 *Shore.* However, the possibility of using cover layers with a different structure, for example formed by a single layer *(as schematically shown in the figures)* or by more than two layers, wherein these layers have different features, also falls within the scope of the invention.

According to the present invention the moving assembly 10 is provided with a plurality of connecting pins 43 connected, directly or indirectly, to the outermost surface 18 of the cylindrical body 11 at a cutoff region 60 of the cover layer 11". Still according to the invention, the pins 43 are arranged parallel to the longitudinal axis 100 of the cylindrical body 11'. Moreover, for each pin 43, the radial distance Ri, R_{1A} between the longitudinal axis 100 and any point of a free end 431 of each pin 43 is less than or equal to the radial distance *(indicated by R₂ in the figures)* between the longitudinal axis 100 and the support surface 11a defined by the outermost surface of the cover layer 11" *(i.e., by the surface of the cover layer 11" farthest from the longitudinal axis 100).*

For the purposes of the invention, the term *"cutoff region 60"* is meant as a space around the cylindrical body 11' in which the cover layer 11' is not present. Hereinafter, the term non-covered portion 18A is instead meant as the portion of the outer surface 18 of the cylindrical body 11' without the cover, i.e., the portion at the cutoff region 60 of the cover layer 11". According to the invention, the pins 43 are fixed, directly or indirectly, to this non-covered portion 18A of the cylindrical body 11'.

For the purposes of the present invention, the *"radial distance"* is considered along a line perpendicular to the longitudinal axis 100 of the cylindrical body 11'and it is the distance between said longitudinal axis 100 and another point of the cylinder 11 *(such as a point of the pin 43 or a point of the cover layer 11"*). In practice, this distance is considered on a transverse *(i.e., orthogonal)* plane with respect to the longitudinal axis 100 of the cylindrical body 11'.

With reference to Figs. 3, 4 and 5, it can be observed that the cutoff region 60 extends along the whole length E of the support cylinder 11, wherein such length is evaluated parallel to the longitudinal axis 100. The cutoff region 60 is defined by a space delimited toward the inside by said non-covered portion 18A and delimited toward the outside by a portion *(shown as a dashed line* *Fig. 3* *and indicated by S)* of a cylindrical reference surface whose radius R₂ *(considered in a cross-sectional plane orthogonal to the axis 100)* corresponds to the radius of the support surface 11a defined by the outermost surface of the cover layer 11". Laterally, the cutoff region 60 is instead delimited by two opposite edge portions B₁, B₂ of the cover layer 11" which develop over the whole length E of the cylinder 11.

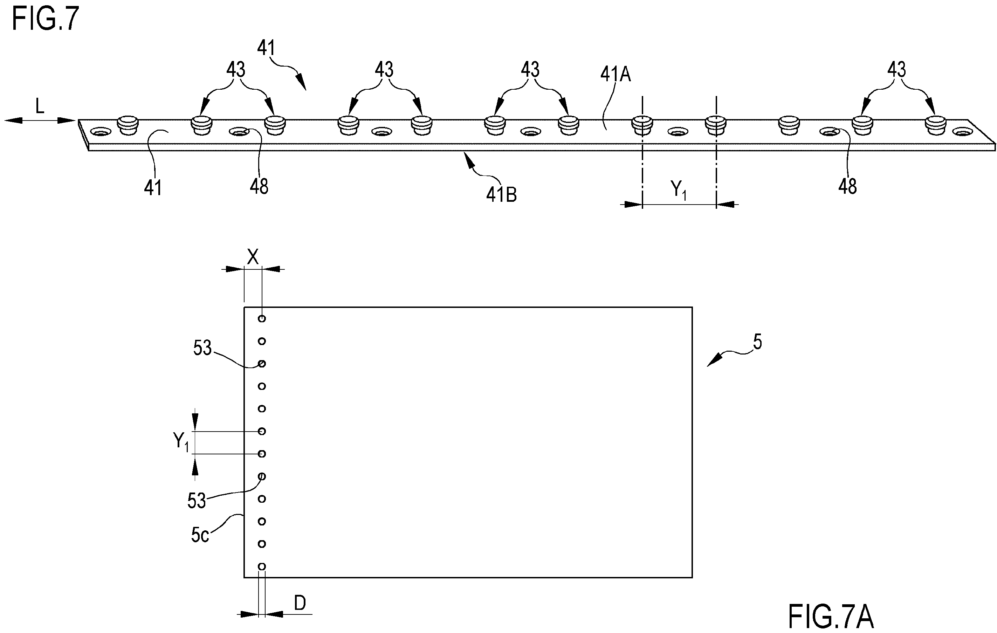

According to the embodiments visible in Figs. 3, 4, 5 and 6, the connecting pins 43 are fixed directly to the non-covered portion 18A of the outermost surface 18 of the cylindrical body 11'. Once connected, the pins 43 extend within the space *(cutoff region 60)* in which there is no cover layer 11" without emerging beyond the portion S of the reference surface defined above. As better explained below, this condition ensures that the pins 43 do not hinder the rotation of the cylinder 11 around the longitudinal axis even when these pins, while drawing the plate 5, come close to the position in which the plate contacts the absorbent material B. Fig. 7A is a schematic view of a flexographic plate 5, having a known shape. The plate 5 can be connected to a cylinder 11 of a moving assembly 10 of an apparatus 1 according to the invention. An edge 5c and a series of holes 53 formed close to the edge 5c at a given distance X therefrom are defined in the plate 5. The holes 53 are spaced from one another by a given centre distance Yi and have a given diameter D.

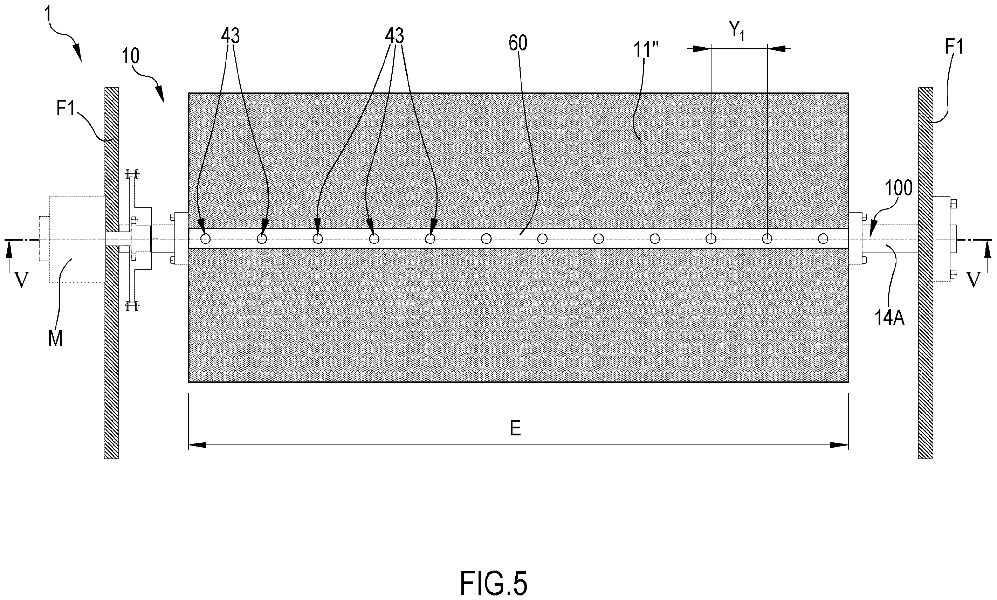

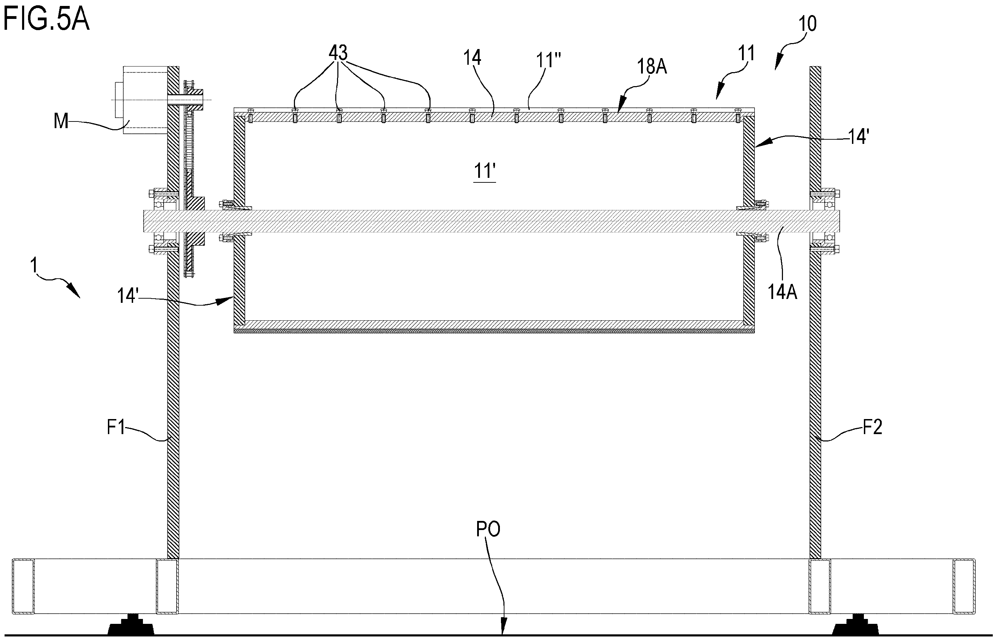

Again with reference to the embodiments in Figs. 3, 4, 5 and 6, preferably the pins are screwed directly to the non-covered portion 18A and are spaced apart from one another by the same centre distance Yi as centre distance of the holes 53 of the plate 5 *(see plan view in* *Fig.* 5). Preferably, the number of the pins 43 is the same as the number of the holes 53 of the plate 5. However, the number of pins 43 could also be less than the number of holes 53. According to a possible embodiment, the non-covered portion 18A is flat-shaped, for example formed by milling the outermost cylindrical surface 18 of the cylindrical body 11'. In an alternative embodiment, the non-covered portion 18A could be curved or coincide with a portion of said outermost cylindrical surface 18.

According to an embodiment illustrated in the figures, the connecting pins 43 have a substantially *"mushroom-shaped"* configuration, having a base 43a connected, directly or indirectly, to the non-covered portion 18A of the outermost surface 18 of the cylindrical body 11', and a head 43b enlarged with respect to the base 43, whereby the diameter of the head 43b is greater than that of the base 43a.

The free end 431 of the pin 43 is defined by the outermost surface of the head 43b. This surface 431 has a circular shape considering the cylinder 11 in a plan view *(as shown for example in* *Fig. 5**).* According to the invention, for each point of this outermost surface 431 its radial distance Ri, R1_{A} from the longitudinal axis 100 of the cylindrical body 11 is less than the radial distance R₂ between the same longitudinal axis 100 and the support surface 11a of the plate 5 as defined by the outer surface of the cover layer 11".

In this regard, in Fig. 3 R_{1A} denotes a first radial distance of the central point Pc of the outermost surface 431 of the end 43b of the pin 43, i.e., the point that lies on the axis IT *(indicated in* *Fig. 4**)* of said pin. Instead, R₁ denotes a second radial distance of the perimeter point Pp of said outermost surface 431 of said end, wherein this point Pp is the farthest from the central point Pc. It can be noted that although said second distance R₁ is greater than the first distance R_{1A}, said second distance R₁ is nonetheless less than the radius *(indicated with R₂)* of the outermost surface of the cover layer 11" *(i.e., than the radius of the support surface 11a).* As already mentioned above, the distance R₂ coincides with the radial distance from the longitudinal axis 100 of a point of the support surface 11a.

With reference to Fig. 4, the diameter di of the base 43a of the pins 43 *(indicated in* *Fig. 4**)* is less than or equal to the diameter D of the holes 53 formed in the plate 5. The diameter d₂ *(indicated in* *Fig. 4**)* of the enlarged head 43b of the pins 43 is instead greater than the diameter di of the base 43a and greater than the diameter D of the holes 53. Preferably, the enlarged head 43b has a tapered configuration, defined by a perimeter chamfer toward the outermost surface 431.

The plate 5 in Fig. 7A can be connected to the pins 43 according in a way shown in detail in Fig. 4. A section *(indicated by L)* of the plate 5 close to the holes 53 is inserted into the cutoff region 60 so that the pins 43 are inserted in the holes 53. This connection requires a certain pressure to allow the holes 53 of the plate 5 to widen for passing the enlarged head 43b of the pins 43 and reach the base 43a of the pins. In this position, the plate 5 remains fastened to the support cylinder 11 also during the rotation thereof, since the enlarged head 43b of the pins 43 prevents detachment of the plate 5.

Again with reference to Fig. 4, the section L of the plate 5 inserted into the cutoff region 60 of the cover layer 11" comprises a first portion L₁ that substantially rests against or in any case is adjacent to the non-covered portion 18A of the cylindrical body 11'. The section L further comprises a second portion L₂, adjacent to the first portion L₁, which is bent toward the outside of the cutoff region 60. This second portion L₂ connects the first portion L₁ to the rest of the plate 5 intended to rest through its inner surface 5b on the support surface 11a of the cylinder 11.

It can be observed that, as a whole, the section L of the plate 5 resulting from the sum of the two portions L₁, L₂ represents the non-usable portion of plate. The Applicant has observed that *(keeping other features of the plate the same)* the extension of this section L, measured from the edge 5c of the plate 5, can be much lower than the length dictated by the constraints in known thermal development apparatus. In fact, the position of the pins 43 in the present invention ensures that the absorbent material B can act on the whole plate 5 leaving out the cutoff region 60 of the cover layer 11". Practice has shown that the section L can have an extension of 20-25 mm, while in plates processed with conventional apparatus the extension of the non-usable section is never less than 40-45 mm. By making the portion L smaller it possible to exploit a greater surface of the plate 5 and hence to reduce the final production costs for plate manufacturers.

According to a preferred embodiment, visible in particular in Fig. 5A, the cylindrical body 11' of the cylinder 11, considered in a cross-sectional plane orthogonal to rotation axis 100 thereof, comprises an outermost cylindrical shell 14 connected to a central shaft 14A by means of longitudinally spaced heads 14', wherein these heads 14' comprise connecting spokes 14" *(visible in* *Figs. 1* *and* *2**).* As a whole, the cylindrical body 11' is internally hollow *(see again* *Fig. 5A**).* Advantageously, this configuration helps to dissipate heat and hence to preserve the integrity of the base layer of the plate 5.

With reference once again to Figs. 5 and 5A, the cylinder 11 is supported by opposed sidewalls F1, F2 of a support frame. More precisely, the shaft 14A is pivoted to these sidewalls so as to allow the cylinder 14A to rotate about the longitudinal axis 100. A motor M, preferably an electric motor, rotates the cylinder 11 at a defined rotation speed.

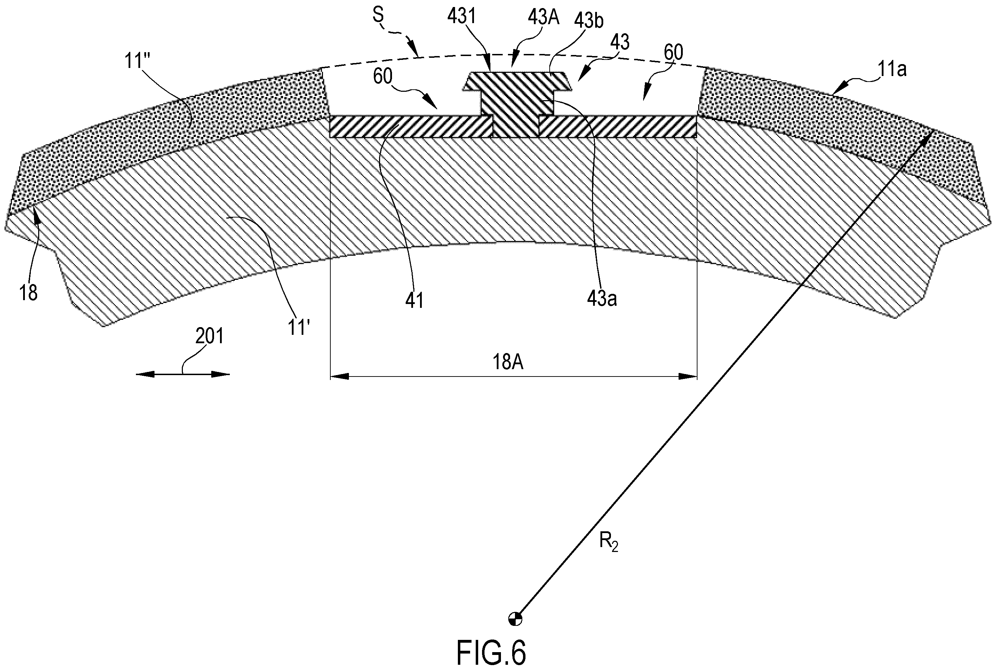

With reference to Figs. 6 and 7, according to an alternative embodiment to the one shown in Figs. 3 and 4, the connecting pins 43 are fixed to a pin bar 41 *(hereinafter also indicated by the term bar 41)* which is fixed to the free surface 18A. Therefore, in this embodiment, the pins 43 are fixed *"indirectly"* to the non-covered portion 18A of the outermost surface 18 of the cylindrical body 11.

Fig. 7 is a schematic view of a pin bar 41 with the pins 43 fixed thereon, for example by means of a threaded coupling. The pin bar 41 develops mainly along a longitudinal direction L, preferably for a length corresponding to the length E of the support cylinder 11. The pins 43 are fixed on the bar 41 so as to emerge from a first surface 41A at intervals Y corresponding to those of the connecting holes 53 formed in the plate 5. Also in this case, the number of pins 43 is equal to or less than the number of connecting holes 53.

The pin bar 41 further comprises a plurality of holes 48 to allow positioning of connecting means *(for example screws of pins)* for connecting the bar 41 *(at a second surface 41B opposite the first surface 41A)* to the non-covered portion 18A of the cylindrical body 11'. With reference to Fig. 6, preferably the non-covered portion 18A of the outer surface 18 of the cylindrical body 11 is defined by a substantially U-shaped seat in which the bar 41 with the pins 43 is arranged. This seat can also be easily obtained by milling a portion of the outermost surface 18 of the cylindrical body. Alternatively, the non-covered portion 18A could be flat-shaped.

According to the principles of the invention, through the connecting means *(not shown in* *Fig. 6**)*, the bar 41 is hence rigidly fastened to the cylindrical body 11' at the cutoff region 60 and hence visible, at least when the plate 5 is not connected to the pins 43. In the embodiment schematically shown, the bar 41 has the same width *(considered along a transverse direction 201)* as the seat, i.e., as the non-covered portion 18A. However, the bar 41 could also have a width smaller than that of the free portion 18A.

With reference once again to Fig. 6, in any case, further to the connection of the bar 41, the pins 43 still remain comprised within the cutoff region 60 according to the principles mentioned above. Therefore, even when the bar 41 is used, the connecting pins 43 do not cause any interference between the support cylinder 11A and the means for applying the absorbent material B to the plate 5.

Figs. 1 and 2 show a first possible embodiment of an apparatus according to the invention wherein the operating assembly 20 has a known configuration. In particular, a heating cylinder 22 is provided, defined by a body made of a metal material and heated by at least one electrical resistor R extending internally through the body. Preferably, this predetermined temperature can vary in a range from 80 and 150 °C depending on the type and/or on the material of which the plate 5 is made. The contact means instead comprise a pushing unit 25 acting on the heating cylinder 22 so as to apply a constant push thereon. The pushing unit 25 is configured as a pair of hydraulic actuators 25A acting on the cylinder 22 at opposite ends thereof. In this embodiment, according to a known principle, the distance between the heating cylinder 22 and the outer surface 5a of the plate 5 is set and adjusted using mechanical means *(not represented in* *Figs. 1* *and* *2**).* Overall, the action of the pushing unit 25 and of these mechanical means helps to define how the contact between the absorbent material B and the outer surface 5b of the plate takes place.

Fig. 1 shows the apparatus 1 without the plate 5, whereas Fig. 2 shows the apparatus 1 during movement of the plate 5, and hence after the latter has been connected to the pins 43 of the moving assembly 10 according to the invention. In particular, from Fig. 2 it readily apparent that, by virtue of the connecting principle according to the invention, the development process takes place continuously and without interruptions; the support cylinder 11 can continue its rotation and the heating roller 22 can maintain its operating position. This is achieved, on the one hand, due to positioning of the pins in the cutoff region 60 of the cover layer 11" and, on the other hand, due to the radial extension of the pins 43, which do not extend beyond the reference circumference having the same radius R₂ as the support surface 11a defined by said cover layer 11".

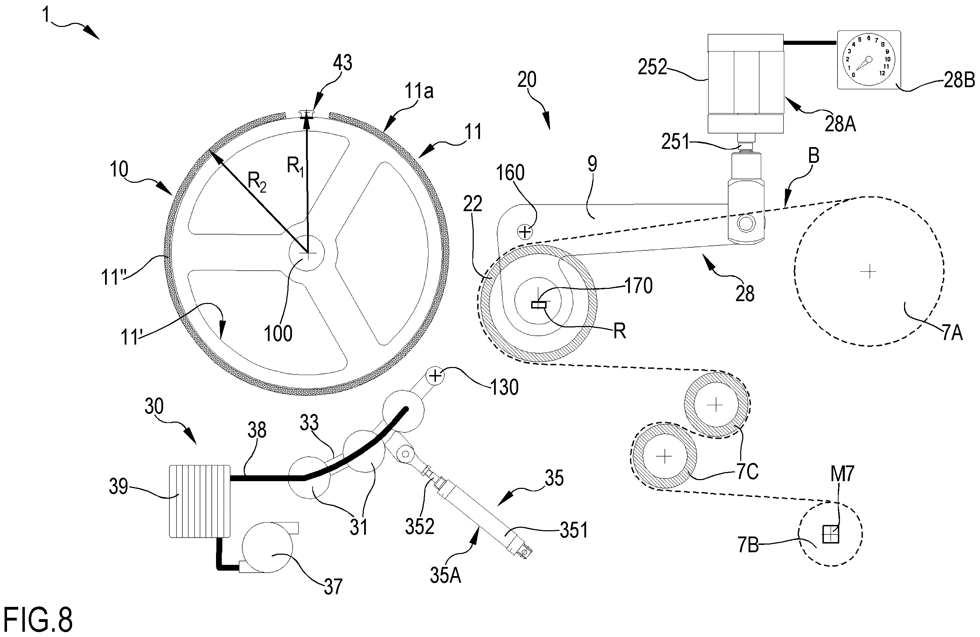

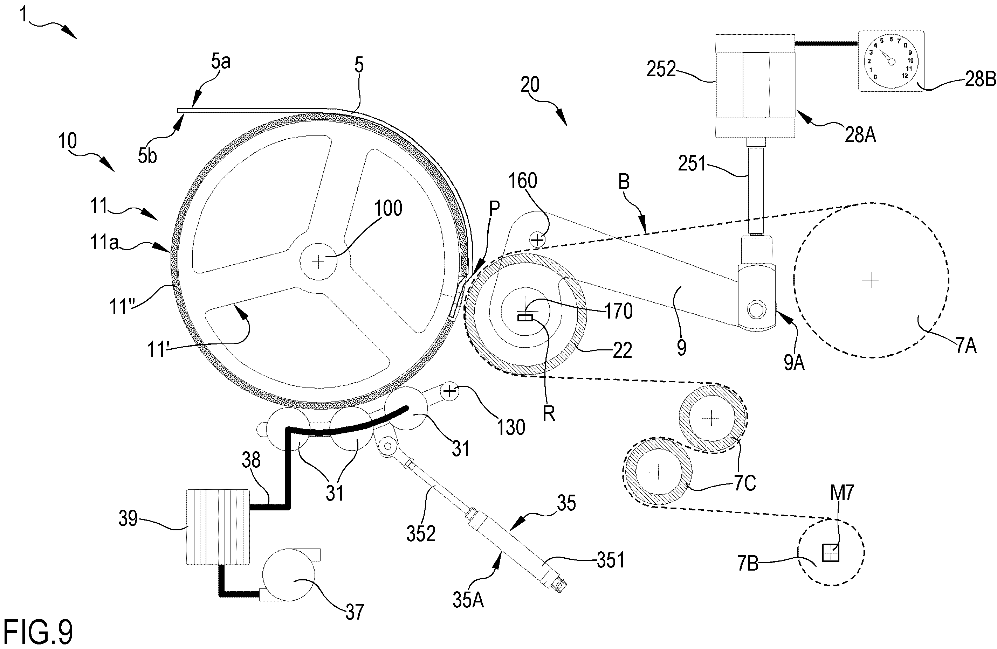

Figs. 8 and 9 refer to a preferred embodiment of the operating assembly 20 that differs from the embodiment shown in Figs. 1 and 2 substantially due to a different configuration of the pushing unit *(indicated by the reference numeral 28 in* *Fig. 8**).* More precisely, in the embodiment of Figs. 8 and 9, the pushing unit 28 comprises a pair of pneumatic actuators 28A, each comprising a cylinder 252 and a rod 251 projecting therefrom which is directly or indirectly connected to the heating cylinder 22 to allow the movement thereof according to a predetermined trajectory. More precisely, for each actuator 28A, the corresponding rod 251 is directly or indirectly connected to the heating cylinder 22 close to an end thereof.

Preferably, the two actuators 28A are indirectly connected to the heating cylinder 22 by a pair of connection levers 9 *(or levers 9),* each hinged to one of the sidewalls F1, F2 of the support frame T, so as to rotate about a common rotation axis 160. For each lever 9, a first end 9A is hinged to the end of the rod 251 of the corresponding actuator 28A, whereas a second end 9B is rotatably connected to the heating cylinder 22 close to end thereof. More precisely, the two connection levers 9 support the heating cylinder 22 at the ends thereof. The axis 170 of the heating cylinder 22 is hence parallel to the common rotation axis 160 of the two levers 9.

As shown in the figures, the two levers 9 have a substantially L-shaped configuration. Therefore, further to the actuation of the actuators 28A, the heating cylinder 22 is moved by the levers 9 along a circular trajectory whose centre of rotation coincides with the common rotation axis 160 of the levers.

In this embodiment, the pushing unit 28 comprises a pressure regulator 28B for adjusting the pressure applied by the rod 251 of each actuator 25A onto the heating roller 22 and, accordingly, the pressure applied by the latter acts onto the plate 5. In particular, the pressure regulator 28B allows the pressure to be varied gradually, by increasing or decreasing it as required, during the movement of the plate 5. The pressure can be varied at each passage of the plate 5 or after a predetermined number of passages. The Applicant observed that the pushing unit 28 described above, and in particular the use of the pressure regulator 28B, represents a simpler and less expensive solution as compared to known solutions. In particular, this solution avoids the use of hydraulic cylinders and mechanical adjustment means typically used to adjust the distance between the heating roller and the plate 5.

In the embodiment of Figs. 8 and 9, the apparatus 1 is further provided with a cooling assembly 30 having the function of cooling the plate 5 in an operating position defined downstream of the operating position at which the absorbent material B contacts the outer surface 5b of the plate 5, wherein these operating positions are considered along the predetermined movement trajectory of the plate 5. In other words, for each rotation of the plate 5, the cooling assembly 30 acts on the plate 5, thereby cooling it, immediately after removal of the polymer/monomer, so as to limit the heat level in said plate, which would tend to increase due to the action of the heating means of the operating assembly 20. Advantageously, the cooling assembly 30 makes it possible to preserve the integrity of the base film of the plate 5, i.e., to prevent or greatly reduce possible deformations/distortions.

In the embodiment shown, the cooling assembly 30 comprises a plurality of cooling cylinders 31 installed in a support structure 33 *(indicated in* *Fig. 8**)* rotatable about a rotation axis 130 parallel to the rotation axis 100 of the support cylinder 11 of the moving assembly 10. In particular, the support structure 33 is rotatable about the rotation axis 100 to move the cooling cylinders 31 between a first reference position, corresponding to a contact condition with the outer surface 5a of the plate 5 *(shown in* *Fig. 9**)*, and a second reference position, corresponding instead to a non-contact position with the outer surface 5b of the plate 5 *(shown in* *Fig. 8**).* The cooling assembly 30 further comprises displacement means 35 configured to move, directly or indirectly, the cooling cylinders 31 between the two reference positions indicated above. The operating means preferably comprise an actuator 35A, for example a hydraulic actuator, comprising a cylinder 352 *(fixed)* and a rod movable with respect to the cylinder 352 and connected to the support structure 33.

Preferably, the temperature value of the outer surface of the cooling cylinders 31 is maintained below a predetermined value, or in a range of predetermined values, by the forced circulation of a cooling fluid, for example water, through the cylinders. In this regard, as schematically shown, said cooling assembly 30 comprises a circulation line 38 of the cooling fluid along which a circulation pump 37 is arranged. A thermal conditioning machine 39 is also provided along the circulation line 38 to condition *(in particular to cool)* the cooling fluid before it enters the cooling cylinders 31. Preferably, the thermal conditioning machine 39 is of the water/water type, but it could also be of the air/water type.

Preferably, but not exclusively, the circulation pump 37 is operatively arranged upstream of the thermal conditioning machine 39 with respect to the flow direction of the cooling fluid in the circulation line 38. According to a preferred operating mode, the thermal conditioning machine 39 and the circulation pump 38 are maintained constantly activated even at the end of the development process of a plate 5 and hence in the idle time before loading and processing another plate.

Although included in a preferred embodiment of the invention, the presence or absence of a cooling assembly 30 for preserving the integrity of the base layer of the plate is not relevant for the present invention. In other words, the moving assembly 10 according to the invention can be installed regardless of the presence of a cooling assembly of the plate 5.

With reference to the embodiment shown in Figs. 8 and 9, the operating mode of the apparatus 1 is described below. With reference to Fig. 8, in the absence of the plate 5, the pushing unit 28 of the heating cylinder 22 is deactivated so that the latter is in the non-operating position, i.e., relatively away from the support cylinder 10. In this condition the cylinders 252 of the actuators 28A are not fed *(zero feed pressure).* At the same time, the cooling cylinders 31 of the cooling assembly 30 are in the second reference position *(non-contact position).*

The heating cylinder 22 is preferably heated before moving the plate 5 by means of the support cylinder 11. More precisely, at least the electrical resistor R is activated so that the temperature of the cylindrical body of the heating roller 22 reaches the desired value. Before moving the plate, the conditioning machine 39 and/or the circulation pump 37 of the cooling assembly are activated to take the cooling cylinders 31 to a predetermined temperature.

After connecting the plate 5 to the connecting pins 43 directly or indirectly fixed, to the cylindrical body 11' of the cylinder 11, the pushing unit 28 of the operating assembly 20 is activated. The two actuators 28A act on the corresponding levers 9 so as to move the heating cylinder 22 into the operating position, i.e., the position in which it contacts the plate 5. More precisely, through the pressure regulator 28B the pressure of the air fed into the cylinders 252 is taken to a predetermined value *(for example 4 bar as indicated by the indicator of the regulating device 28B schematically shown in* *Fig. 9**).* Simultaneously or not, the displacement means 35 of the cooling assembly 30 are also activated so as to take the cooling cylinders 31 into the first reference position, i.e., the position in which they can contact the plate 5 to cool it.

After connecting the plate 5 to the cylinder 11, the motor M for rotating the cylinder 11 and the motor M7 for rotating the collecting cylinder 7B are operated respectively to move the plate 5 and feed the absorbent material B. By means of the heating cylinder 22, the non-crosslinked polymer-monomer is melted and removed from the outer surface 5a of the plate 5 due to the action of the absorbent material B fed around the heating cylinder 22. Further to the movement of the plate 5, the surface portion thereof from which the polymer or monomer has just been removed contacts the cooling cylinders 31 of the moving assembly 30. In this way, the diffusion of heat inside the plate 5 is counteracted, and consequently the temperature increase in the base layer is also effectively counteracted.

With reference to Fig. 9 it can be observed that, by positioning the connecting pins 43 within the cutoff region 60 of the cover layer 11", the absorbent material B that envelops the heating roller 22 can contact the first surface 5a at a point *(indicated by P* in* *Fig. 9**)* immediately outside the aforesaid cutoff region 60. Therefore, keeping other dimensions and features of the plate 5 the same, this connection principle allows maximizing the surface of the plate that can be thermally developed.

The operation described above is preferably automated using a control unit *(not indicated in the figures)* through which it is possible to control the motor M for moving the cylinder 11, the motor M7 for motorizing the collecting cylinder 7B of the feeding means, the displacement means 35 of the cooling assembly 30, and the pushing unit 28 *(in particular the actuators 28A)* of the development assembly 20. In particular, through the same control unit, it is possible to control the thermal conditioning machine 39 and/or activation/deactivation of the electrical resistor(s) for heating the heating roller 22. Moreover, through the same control unit, it is possible to control the pressure regulator 28B and hence to vary *(i.e., increase of decrease)* as required *(for example based on the type of plate and*/*or the type of design)* the pressure with which the actuators 25A act on the heating cylinder 22, i.e., vary the position of the latter relative to the plate 5.

In general, through the control unit it is possible to set the operating parameters of the thermal development process of the plate and in particular the operating temperature of the heating roller and the pressure with which it acts on the plate 5, the feed speed of the absorbent material B and the feed speed of the plate 5 and, in the specific case shown in Figs. 8 and 9, the operating temperature of the cooling cylinders 31.

The solutions described above allow the set aims and objects to be fully achieved. In particular, the moving assembly 10 of the apparatus according to the invention provides an easier connection of the plate to the cylinder 11, which allows the thermal development process to be carried out continuously and without interruptions. Moreover, this connection allows the surface of the plate that can be thermally developed to be maximised and hence offers a considerable advantage for plate manufacturers.

As indicated above, the use of a moving assembly 10 according to the principles of the present invention is independent of the configuration of the development operating assembly, and also independent of the presence or absence of a cooling assembly, Therefore, the moving assembly, and the cooling assembly if provided, can have configurations which differ from those described and shown in the figures, in particular configurations already known to the person skilled in the art.

## Claims

1. A thermal development apparatus (1) for removing non-crosslinked polymer or monomer from a first surface (5a) of a flexographic plate (5), wherein said apparatus (1) comprises:
- a moving assembly (10) defining a support surface (11a) for a second surface (5b) of said flexographic plate (5) opposite said first surface (5a), wherein said moving assembly (10) moves said flexographic plate (5) along a predetermined trajectory;
- a development operating assembly (20) for applying an absorbent material (B) to said first surface (5a) of said flexographic plate (5) during the movement thereof, wherein said development operating unit (20) comprises:
- feeding means (7A, 7B, 7C) of said absorbent material (B);
- heating means (22, R) for heating said outer surface (5a) of said flexographic plate (5) to a temperature sufficient to melt at least a portion of said non-crosslinked polymer/monomer;
- contact means (25, 28) configured to cause a contact between said absorbent material (B) and said first surface (5a) of said flexographic plate (5) to allow said melted polymer/monomer to be absorbed by said absorbent material (B),
**characterized in that** said moving assembly (10) comprises a support cylinder (11) which includes a cylindrical body (11') that develops around a longitudinal axis (100), wherein said support cylinder (11) further includes a cover layer (11') which partially covers an outermost surface (18) of said cylindrical body (11) and defines said support surface (11a) for said plate (5), wherein said moving assembly (10) comprises a plurality of connecting pins (43) connected, directly or indirectly, to said outermost surface (18) of said cylindrical body (11) at a cutoff region (60) of said cover layer (11'), wherein said pins (43) are aligned parallel to said longitudinal axis (100) and wherein, for each pin (43), the radial distance (R1, R*) between said longitudinal axis (100) and a free end (431) of said pin (43) is less than the radial distance (R₂) between said longitudinal axis (100) and the support surface (11a) defined by said cover layer (11').

2. Apparatus (1) according to claim 1, wherein at least one of said pins (43) comprises a base (43a) connected, directly or indirectly, to a non-covered portion (18A) of said outermost surface (18) of said cylindrical body (11') at said cutoff region (60) and a head (43b) enlarged with respect to said base (43a), wherein said enlarged head (43b) defines said free end (431) of said pin (43).

3. Apparatus (1) according to claim 2, wherein said pins (43) are fixed directly to said non-covered portion (18A) by means of a threaded coupling.

4. Apparatus (1) according to claim 3, wherein said non-covered portion (18A) is flat-shaped.

5. Apparatus (1) according to claim 1 or 2, wherein said pins (43) are fixed to a pin bar (41) so as to emerge with respect to a first surface (41A) thereof, said pin bar (41) being fixed directly, at a second surface (41B) opposite said first surface (41A), to said non-covered portion (18A) of said outermost surface (18) of said cylindrical body (11').

6. Apparatus (1) according to claim 5, wherein said pins (43) are fixed to said pin bar (41) and wherein said bar (41) comprises a plurality of holes (48) for positioning connecting means for connecting said bar (41) to said non-covered portion (18A) of said cylindrical body (11').

7. Apparatus (1) according to any one of claims 1 to 6, wherein said cover layer (11') comprises at least two sub-layers, an innermost sub-layer having a hardness of around 40 Shore and an outermost sub-layer having a hardness of around 20 Shore.

8. Apparatus (1) according to any one of the preceding claims, wherein said cylindrical body (11'), considered in a cross-sectional plane orthogonal to said longitudinal axis (100), comprises an outermost cylindrical shell (14) connected to a central shaft (14A) by means of heads (14'), wherein said cylindrical shell (14) is internally hollow and traversed by said central shaft (14A), said heads (14') comprising connecting spokes (14") between said central shaft (14A) and said cylindrical shell (14).
